(19) Europäisches Patentamt
European Patent Office
Office européen des brevets

(11) EP 2 838 119 A1

(12) **EUROPEAN PATENT APPLICATION**

(43) Date of publication:
**18.02.2015 Bulletin 2015/08**

(51) Int Cl.:
***H01L 31/0216*** *(2014.01)* ***H01L 31/0749*** *(2012.01)*

(21) Application number: **14181084.6**

(22) Date of filing: **14.08.2014**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **14.08.2013 KR 20130096899**

(71) Applicant: **Samsung SDI Co., Ltd.**
**Yongin-si, Gyeonggi-do (KR)**

(72) Inventors:
- **Kim, Sung-Su**
  **Gyeonggi-do (KR)**
- **Park, Soo-Youn**
  **Gyeonggi-do (KR)**
- **Park, Do-Young**
  **Gyeonggi-do (KR)**
- **Park, Hye-Jin**
  **Gyeonggi-do (KR)**
- **Park, Jong-Hwan**
  **Gyeonggi-do (KR)**
- **Lee, Ji-Won**
  **Gyeonggi-do (KR)**
- **Eom, Sang-Hyun**
  **Gyeonggi-do (KR)**

(74) Representative: **Taor, Simon Edward William et al**
**Venner Shipley LLP**
**200 Aldersgate**
**London EC1A 4HD (GB)**

# (54) Solar Cell Module and Method of Manufacturing the Same

(57) Solar cell module and method of manufacturing the same, wherein the solar cell module includes: a solar cell that includes a light absorption layer (3) including a p-type compound semiconductor, a buffer layer (4) disposed on the light absorption layer, and a window layer (5) that is disposed on the buffer layer and includes an n-type metal oxide semiconductor; a reflection-prevention layer (6) disposed on the window layer of the solar cell; an adhesive layer (7) disposed on the reflection-prevention layer; and a cover layer (8) disposed on the adhesive layer, wherein the reflection-prevention layer includes an organic compound.

**FIG. 1**

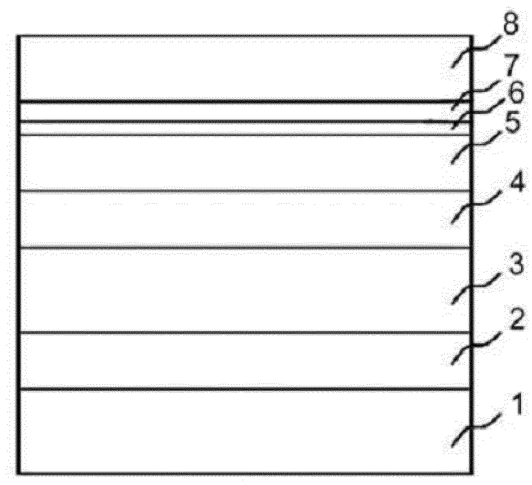


EP 2 838 119 A1

## Description

One or more embodiments of the present invention relate to a solar cell module and a method of manufacturing the same.

Solar cells are representative devices of alternative energy since they directly convert solar energy into electric energy, produce less pollution, and are semi-permanent.

A solar cell may include a window layer, which is a transparent electrode, and a reflection-prevention layer that is disposed on the window layer to prevent loss of incident light due to reflection. The reflection-prevention layer may have a refractive index of about 1.4 in consideration of refractive indexes of the window layer and air.

However, a solar cellis typically used in the form of a solar cell module, and in such a solar cell module, an adhesive layer and a cover layer are additionally disposed on the solar cell. Accordingly, the reflection-prevention layer may have a refractive index of about 1.7 in further consideration of the refractive indexes of the adhesive layer and the window layer.

In general, a material for forming the reflection-prevention layer disposed between the window layer and the adhesive layer in the solar cell module is an inorganic material, such as silicon nitride (SiNx).

However, when the reflection-prevention layer is formed by using the inorganic material, expensive equipment is required and also, high-temperature film forming conditions are required.

Accordingly, there is a need for a new material and a new method of forming a reflection-prevention layer for a solar cell module.

An aspect of the present invention is directed toward a solar cell module including a new reflection-prevention layer.

Another aspect of the present invention is directed toward a method of manufacturing the solar cell module.

Additional aspects will be set forth in part in the description which follows and, in part, will be apparent from the description, or may be learned by practice of the presented embodiments.

According to one or more embodiments of the present invention, a solar cell module includes: a solar cell including: a light absorption layer including a p-type compound semiconductor, a buffer layer on the light absorption layer, and a window layer on the buffer layer that includes an n-type metal oxide semiconductor; a reflection-prevention layer on the window layer of the solar cell; an adhesive layer on the reflection-prevention layer; and a cover layer on the adhesive layer, wherein the reflection-prevention layer includes an organic compound.

According to one or more embodiments of the present invention, a method of manufacturing a solar cell module includes: preparing a solar cell including a window layer; forming a reflection-prevention layer having an organic compound on the window layer of the solar cell; and sequentially disposing an adhesive layer and a cover layer on the reflection-prevention layer in this stated order.

According to an aspect of the invention, there is provided a solar cell module as set out in claim 1. Preferred features of this aspect are set out in claims 2 to 13.

According to an aspect of the invention, there is provided a method of manufacturing a solar cell module as set out in claim 14. Preferred features are set out in claim 15.

These and/or other aspects will become apparent and more readily appreciated from the following description of the embodiments, taken in conjunction with the drawing that is a schematic view of a thin-film solar cell module according to an embodiment of the present invention.

Reference will now be made in more detail to embodiments, examples of which are illustrated in the accompanying drawings, wherein like reference numerals refer to the like elements throughout. In this regard, the present embodiments may have different forms and should not be construed as being limited to the descriptions set forth herein. Accordingly, the embodiments are merely described below, by referring to the figures, to explain aspects of the present description. Expressions such as "at least one of," when preceding a list of elements, modify the entire list of elements and do not modify the individual elements of the list. Further, the use of "may" when describing embodiments of the present invention refers to "one or more embodiments of the present invention."

Hereinafter, solar cell modules according to embodiments of the present invention and methods of manufacturing the same, according to embodiments of the present invention, will be described in more detail.

A solar cell module according to an embodiment of the present invention includes: a solar cell that includes a light absorption layer including a p-type compound (or alloy) semiconductor, a buffer layer disposed on the light absorption layer, and a window layer that is disposed on the buffer layer and includes an n-type metal oxide semiconductor; a reflection-prevention layer disposed on the window layer of the solar cell; an adhesive layer disposed on the reflection-prevention layer; and a cover layer disposed on the adhesive layer.

The reflection-prevention layer of the solar cell module may include an organic compound, and due to the inclusion of the organic compound, the solar cell module may have a reduced reflection ratio and an improved conversion efficiency. A thickness and a refractive index of the reflection-prevention layer including the organic compound may be controlled in consideration of the refractive indexes of the adhesive layer and the window layer, and by doing so, efficiency

of the solar cell module may be improved.

The organic compound included in the reflection-prevention layer of the solar cell module may have a refractive index of about 1.50 to about 2.0. When the refractive index of the organic compound is less than 1.50 or exceeds 2.0, a difference in the refractive indexes of the reflection-prevention layer and adjacent layers thereto is too high or too low. Accordingly, efficiency of the solar cell may decrease.

For example, the refractive index of the organic compound may be in a range of about 1.55 to about 1.95. For example, the refractive index of the organic compound may be in a range of about 1.60 to about 1.90. For example, the refractive index of the organic compound may be in a range of about 1.65 to about 1.85. For example, the refractive index of the organic compound may be in a range of about 1.70 to about 1.80. When the refractive index of the organic compound is within these ranges, the solar cell may have improved solar cell efficiency.

In the solar cell module, the organic compound may absorb light having a wavelength of 380 nm or less. The organic compound mainly absorbs light having a wavelength of 380 nm or less, and the absorption rate of the organic compound with respect to light having a wavelength of 400 nm or more is low. Accordingly, the organic light does not reduce the transmittance of solar light.

For example, in the solar cell module, the organic compound may have an absorption of solar light having a wavelength of 400 nm or more in a range of about 0% to about 5%. For example, in the solar cell module, the reflection-prevention layer including the organic compound may have an absorption of solar light having a wavelength of 400 nm or more in a range of about 0% to about 3%. For example, in the solar cell module, the reflection-prevention layer including the organic compound may absorb about 0% to about 1% solar light having a wavelength of 400 nm or more.

In the solar cell module, a glass transition temperature of the organic compound may be 70°C or more. Accordingly, the reflection-prevention layer may be formed either by vacuum thermal evaporation at a temperature of 70°C or higher or by wet-coating and performing a heat treatment at a temperature of 70°C or higher. The organic compound may have improved thermal stability. A compound having a glass transition temperature of less than 70°C may undergo a change in phase in the procedure of forming the reflection-prevention layer, and thus, a reflection-prevention layer having a homogeneous refractive index may not be formed. For example, a glass transition temperature of the organic compound may be 70°C to 300°C.

For example, in the solar cell module, a glass transition temperature of the organic compound may be 80°C or more. For example, in the solar cell module, a glass transition temperature of the organic compound may be 90°C or more. For example, in the solar cell module, a glass transition temperature of the organic compound may be 100°C or more. For example, in the solar cell module, a glass transition temperature of the organic compound may be 110°C or more. For example, in the solar cell module, a glass transition temperature of the organic compound may be 120°C or more. For example, in the solar cell module, a glass transition temperature of the organic compound may be 130°C or more. For example, in the solar cell module, a glass transition temperature of the organic compound may be 140°C or more. For example, in the solar cell module, a glass transition temperature of the organic compound may be 150°C or more.

The organic compound included in the reflection-prevention layer of the solar cell module may be a compound that transports electrons, a compound that transports holes, or a compound that emits light due to the recombination of electrons and holes, in an electric field.

For example, the organic compound included in the reflection-prevention layer of the solar cell module may be a compound having a hole transport capability in an electric field. For example, the organic compound may be a hole transport material. In particular, a compound having a hole transport capability may have a refractive index of about 1.5 to about 2.0 and a glass transition temperature of 70°C or more, and absorbs light having a wavelength of 380 nm or less.

For example, a compound having a hole transport capability may be a triphenylamine-based compound. The triphenylamine-based organic compound may be selected from a carbazole derivative (such as N-phenylcarbazole, or polyvinylcarbazole), N,N'-bis(3-methylphenyl)-N,N'-diphenyl-[1,1-biphenyl]-4,4'-diamine (TPD), N,N'-bis(naphthalen-2-yl)-N,N'-bis(phenyl)-benzidine (NPB), N,N'-bis(naphthalen-1-yl)-N,N'-bis(phenyl)-2,2'-dimethylbenzidine (α-NPD), 4,4',4"-tris(N-carbazolyl)triphenylamine (TCTA), N,N'-bis(naphthalen-2-yl)-N,N'-bis(phenyl)-benzidine (β-NPB), N,N'-bis(3-methylphenyl)-N,N'-bis(phenyl)-9,9-dimethyl-fluorene (DMFL-TPD), N,N'-bis(naphthalen-1-yl)-N,N'-bis(phenyl)-9,9-dimethyl-fluorene (DMFL-NPB), N,N'-bis(3-methylphenyl)-N,N'-bis(phenyl)-9,9-diphenyl-fluorene (DPFL-TPD), N,N'-bis(naphthalen-1-yl)-N,N'-bis(phenyl)-9,9-diphenyl-fluorene (DPFL-NPB), N,N'-bis(naphthalen-1-yl)-N,N'-bis(phenyl)-2,2'-dimethylbenzidine (α-NPD), 9,9-bis[4-(N,N-bis-naphthalen-2-yl-amino)phenyl]-9H-fluorene (NPAPF), 9,9-bis[4-(N-naphthalen-1-yl-N-phenylamino)-phenyl]-9H-fluorene (NPBAPF), N,N'-bis(phenanthren-9-yl)-N,N'-bis(phenyl)-benzidine (PAPB), di-[4-(N,N-ditolyl-amino)-phenyl]cyclohexane (TAPC), N,N,N',N'-tetra-naphthalen-2-yl-benzidine (β-TNB), N, N,N',N'-tetra-(3-methylphenyl)-3,3'-dimethylbenzidine (HMTPD), N,N'-di(naphthalenyl)-N,N'-di(naphthalen-2-yl)-benzidine (α,β-TNB), N,N,N',N'-tetra-naphthalenyl-benzidine (α-TNB), or N,N'-di(naphthalen-2-yl)-N,N'-diphenylbenzene-1,4-diamine (β-NPP):

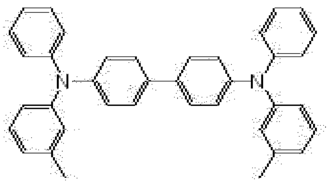
TPD

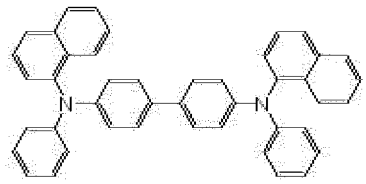
NPB

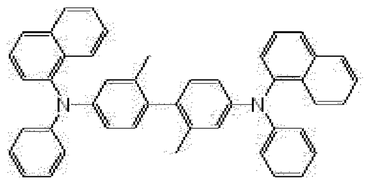
α-NPD

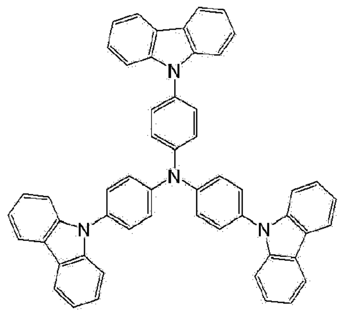
TCTA

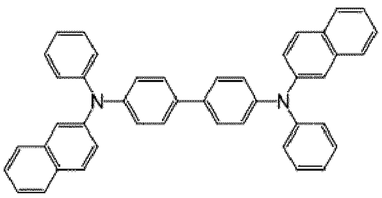
β-NPB

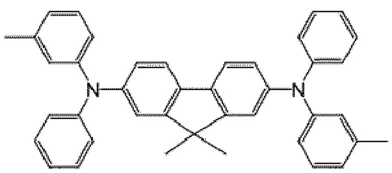
DMFL-TPD

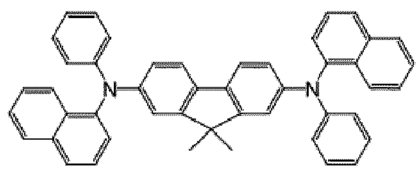
DMFL-NPB

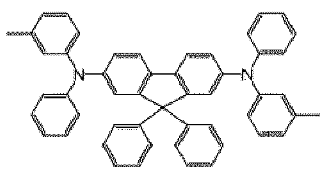
DPFL-TPD

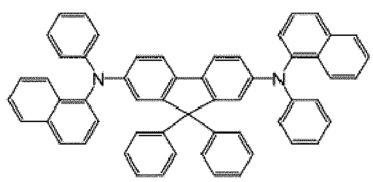
DPFL-NPB

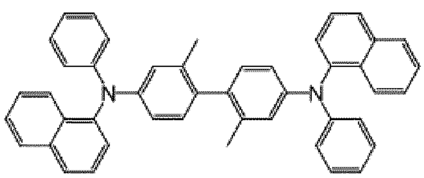
α-NPD

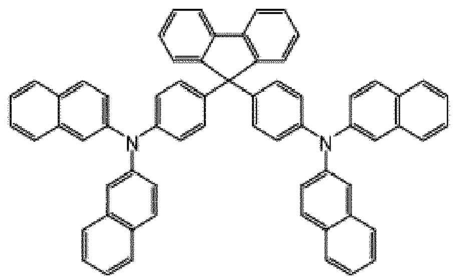
NPAPF

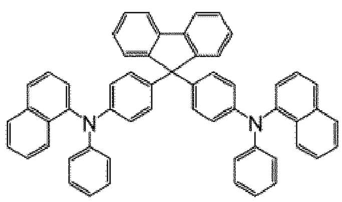
NPBAPF

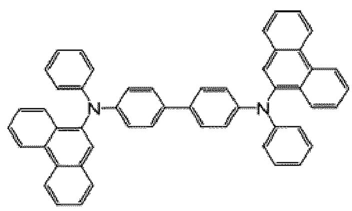
PAPB

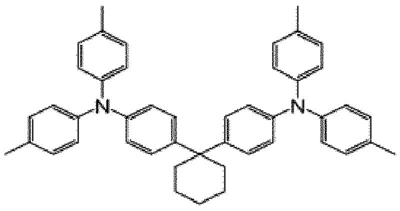
TAPC

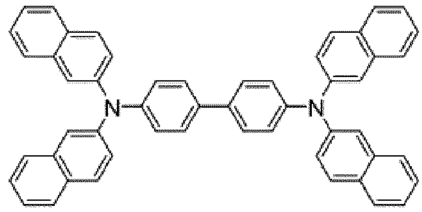
β-TNB

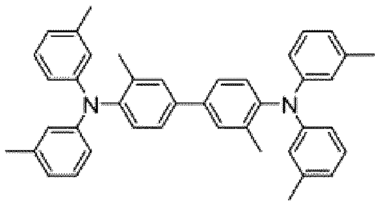
HMTPD

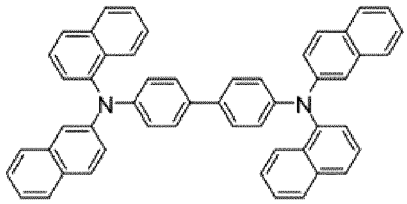
α,β-TNB

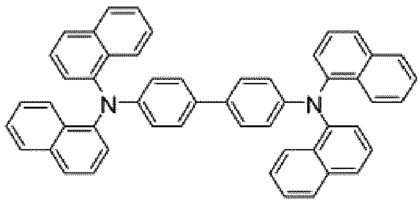
α-TNB

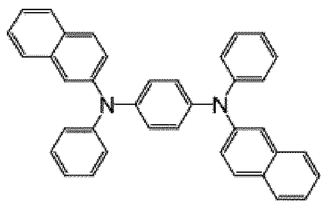
β-NPP

For example, the triphenylamine-based organic compound may be selected from N,N'-diphenyl-N,N'-bis-[4-(phenyl-m-tolyl-amino)-phenyl]-biphenyl-4,4'-diamine (DNTPD), a phthalocyanine compound (such as copper phthalocyanine), 4,4',4"-tris(3-methylphenylphenylamino)triphenylamine (m-MTDATA), 4,4'4"-tris(N,N-diphenylamino)triphenylamine (TDATA), or 4,4',4"-trisN,-(2-naphthyl)-N-phenylamino-triphenylamine (2T-NATA).

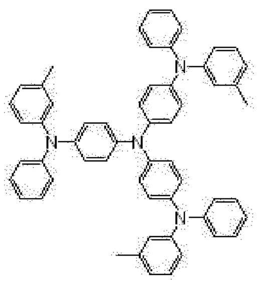
m-MTDATA

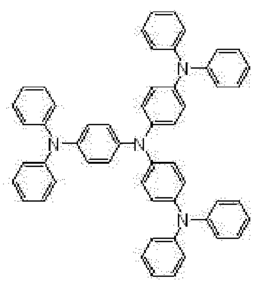
TDATA

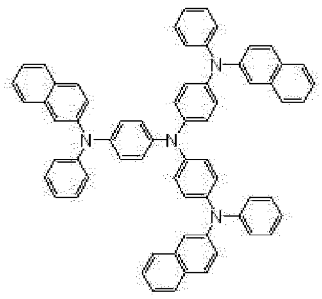
2T-NATA

According to some embodiments of the present invention, the organic compound having a hole transport capability may further include, in addition to the triphenylamine-based compound, at least one compound selected from a carbazole-based compound, a fluorene-based compound, a compound having a spiro structure, a conductive polymer, or a compound that is capable of forming a polymer when exposed to light.

For example, the carbazole-based organic compound may be 4,4',4"-tris(carbazol-9-yl)triphenylamine (TCTA).

For example, the organic compound having a spiro structure may be a spiro compound, such as spiro-TAD (2,2',7,7'-tetrakis(diphenylamino)-9,9'-spirobifluorene), spiro-TPD (N,N'-Bis(3-methylphenyl)-N,N'-diphenyl-9,9-spirobifluorene-2,7-diamine), spiro-NPB(N,N'-bis(naphthalen-1-yl)-N,N'-bis(phenyl)-9,9-spirobifluorene), spiro-TAD (2,2',7,7'-tetrakis(N,N-diphenylamino)-9,9-spirobifluorene), spiro-2NPB(2,2',7,7'-tetrakis[N-naphthalenyl(phenyl)-amino]-9,9-spirobifluorene), 2,2'-spiro-DBP (2,2'-bis[N,N-bis(biphenyl-4-yl)amino]-9,9-spirobifluorene), spiro-BPA (2,2'-bis(N,N-diphenyl-amino)-9,9-spirobifluorene), or spiro-TTB

(2,2',7,7'-tetra(N,N-ditolyl)amino-9,9-spiro-bifluorene). However, the organic compound having a spiro structure of embodiments of the invention is not limited thereto, and may be any one of various compounds that have a hole transport capability in an electric field.

For example, the fluorene-based organic compound may be TPFI. When R is H, the compound is TPFI. When

R is $OCH_3$, the compound is TPFI-OMe. When R is F, the compounds is TPFI-F.

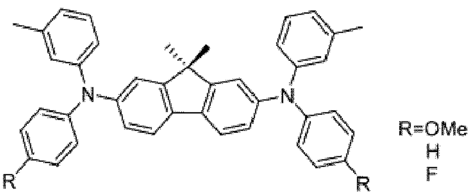

TPFI ;

For example, the conductive polymer and the compound that is capable of forming a polymer when exposed to light may be selected from polyaniline/dodecylbenzenesulfonic acid (PANI/DBSA), poly(3,4-ethylenedioxythiophene)/poly(4-styrenesulfonate) (PEDOT/PSS), polyaniline/camphor sulfonicacid (PANI/CSA), (polyaniline)/poly(4-styrenesulfonate) (PANI/PSS), PVK, PPV, polyarylamine, PS-TPD-TFV, TPA-TFVE, Cz-TFVE, TPD-TFVE, or TriTFV-TCTA, but they are not limited thereto in embodiments of the invention, and may be any one of various suitable materials that have a hole transport capability in an electric field or that is capable of forming a polymer when exposed to light.

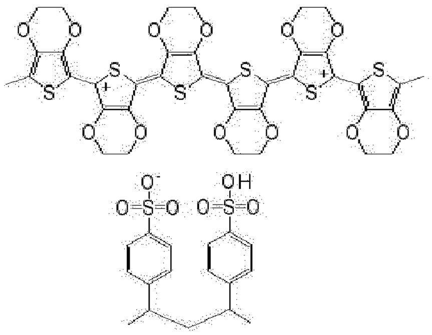

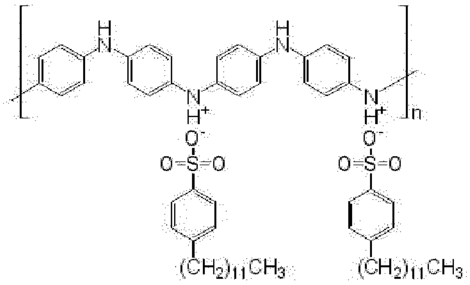

PEDOT/PSS PANI/DBSA

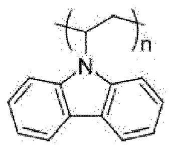

PVK

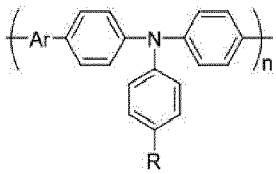

Polyarylamine

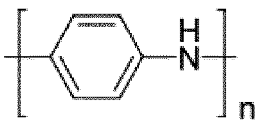

PANI

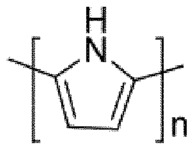

PPY

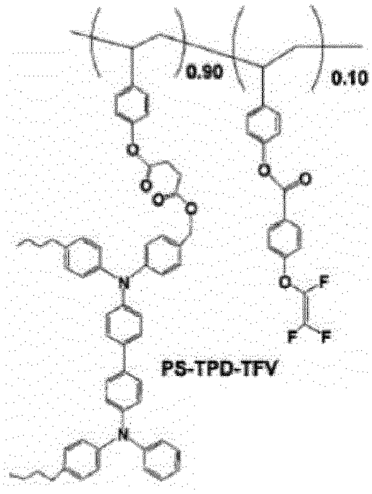

PS-TPD-TFV

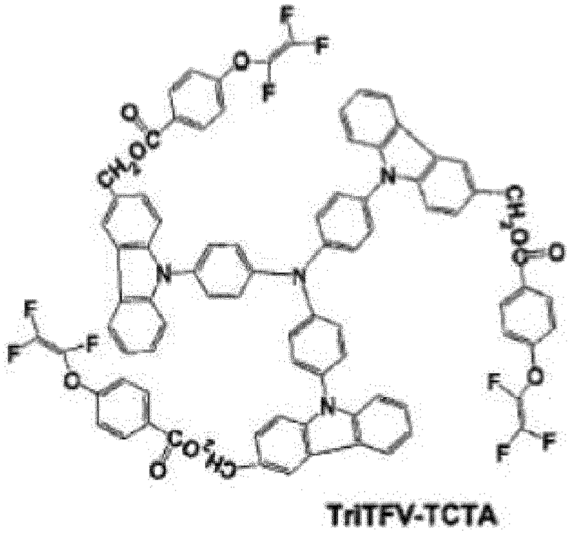

TriTFV-TCTA

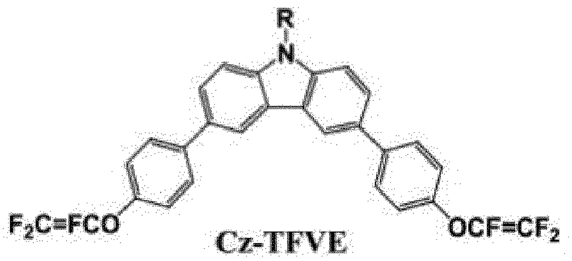

Cz-TFVE

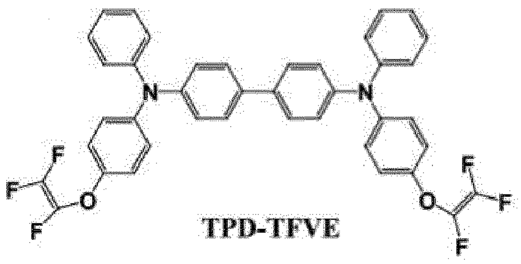

TPD-TFVE

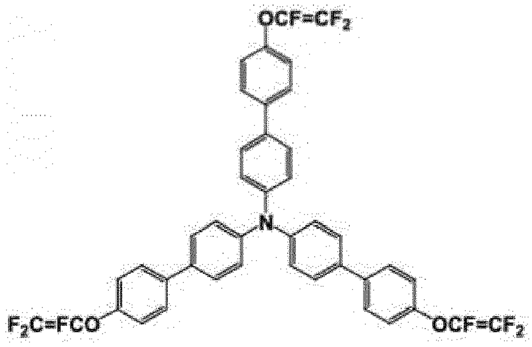

TPA-TFVE

The reflection-prevention layer of the solar cell module may further include, in addition to or instead of an organic compound having a hole transport capability, an organic compound that has an electron transport capability in an electric field. For example, the organic compound may be an electron transport material.

The electron transport material may include at least one compound selected from a phenanthroline-based compound, an oxadiazole-based compound, or a triazole-based compound.

For example, the electron transport material may be a phenanthroline-based compound. For example, the phenanthroline-based compound may be 2,9-dimethyl-4,7-diphenyl-1,10-phenanthroline (BCP), 4,7-diphenyl-1,10-phenanthroline (Bphen), or 2,9-bis(naphthalen-2-yl)-4,7-diphenyl-1,10-phenanthroline (NBphen).

For example, the electron transport material may be an oxadiazole-based compound. For example, the oxadiazole-based compound may be 1,3-bis[2-(4-tert-butylphenyl)-1,3,4-oxadiazo-5-yl]benzene(OXD-7), 1,3-bis[2-(2,2'-bipyridine-6-yl)-1,3,4-oxadiazo-5-yl]benzene (Bpy-OXD), or 6,6'-bis[5-(biphenyl-4-yl)-1,3,4oxadiazo-2-yl]-2,2'-bipyridyl (BP-OXD-Bpy).

For example, the electron transport material may be a triazole-based compound. For example, the triazole-based compound may be 3-(4-biphenyl)-4-phenyl-5-tert-butylphenyl-1,2,4-triazole (TAZ), or 4-(naphthalen-1-yl)-3,5-diphenyl-4H-1,2,4-triazole (NTAZ).

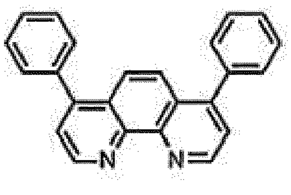

Bphen

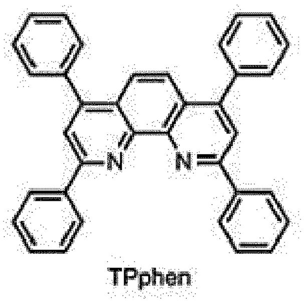

TPphen

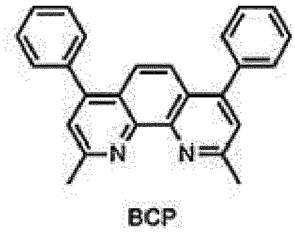

BCP

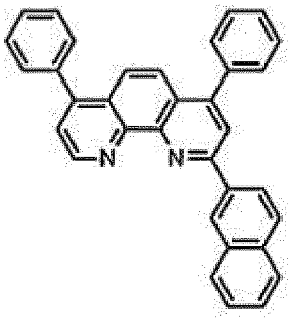

HNBphen

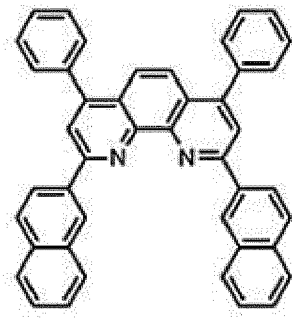

NBphen

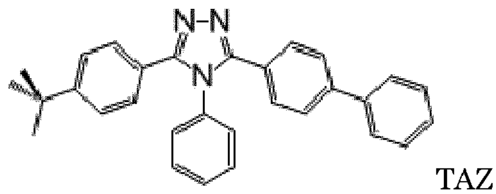

TAZ

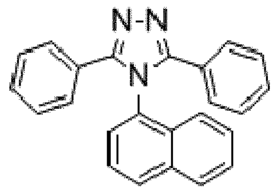

NTAZ

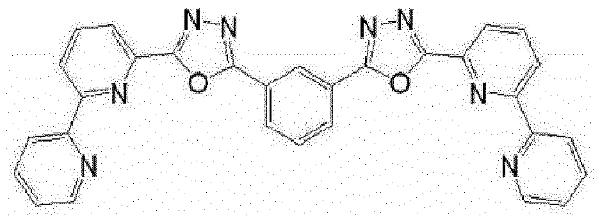

Bpy-OXD

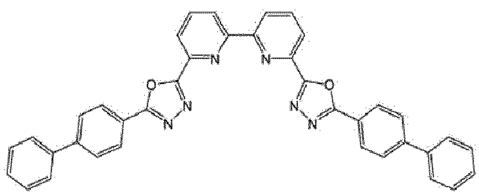

BP-OXD-Bpy

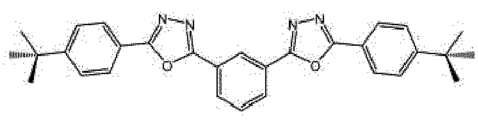

OXD-7

The reflection-prevention layer of the solar cell module may further include, in addition to or instead of an organic compound having a hole transport capability (or an electron transport capability), an organic compound that has a light-emission capability in an electric field.

For example, the organic compound that has a light-emission capability may be an organic compound that emits fluorescent light or an organic compound that emits phosphorescent light.

For example, the organic compound that emits fluorescent light may include at least one compound selected from an anthracene-based compound, a biphenyl-based compound, a methylphenyl-based compound, a spirobifluorene-based compound, a pyrene-based compound, a pentacene-based compound, a perylene-based compound, a phenylene-based compound, a pyrenyl-based compound, or a naphthalene-based compound.

For example, the organic compound that emits phosphorescent light may include at least one compound selected from a carbazole-based compound, a triphenylsilyl-based compound, a dimethylamino-based compound, a methylphenyl-based compound, or a t-butylphenyl-based compound.

Detailed examples of the organic compound that has a light-emission capability are 4,4'-N,N'-dicabazole-biphenyl, 4,4'-N,N'-dicarbazol-biphenyl (CBP), 4,4'-bis(carbazol-9-yl)-2,2'-dimethylbiphenyl (CDBP), poly(n-vinylcabazole) (PVK), 9,10-di(naphthalene-2-yl)anthracene (ADN), TCTA, 1,3,5-tris(N-phenylbenzimidazole-2-yl)benzene (TPBI), 3-tert-butyl-9,10-di(naphth-2-yl) anthracene (TBADN), distyrylarylene (DSA), $E_3$, dmCBP (illustrated below), and Compounds 301 to 309 illustrated below, but embodiments of the invention are not limited thereto.

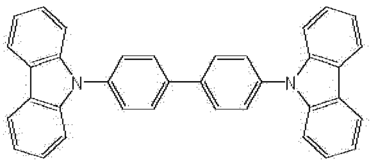

CBP

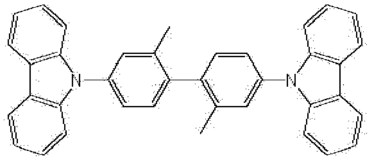

dmCBP

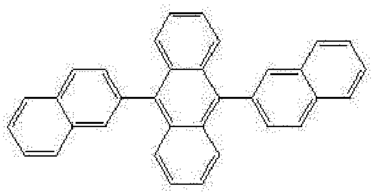

ADN

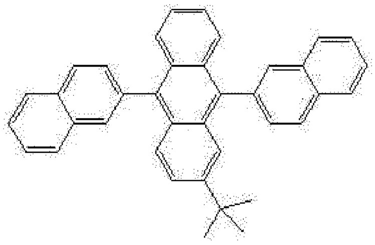

TBADN

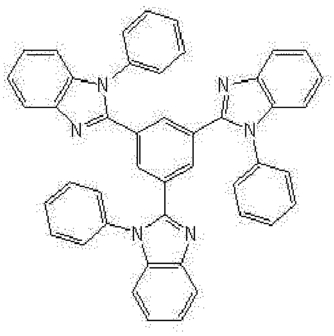

TPBI

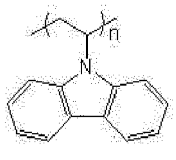

PVK

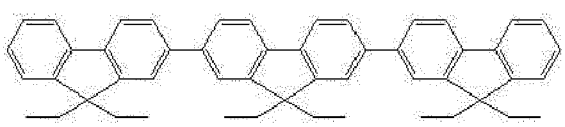

E3

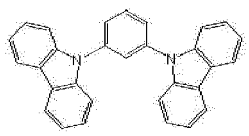
301

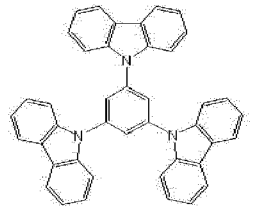
302

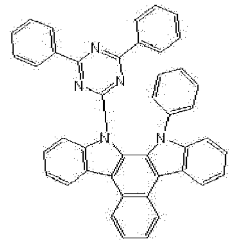
303

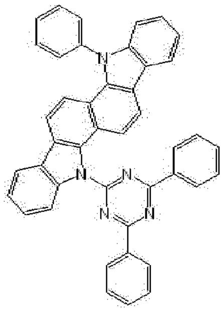
304

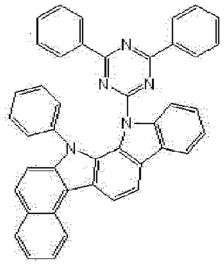
305

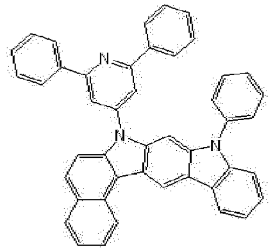
306

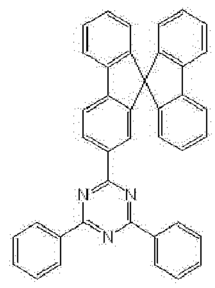
307

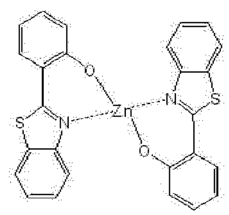
308

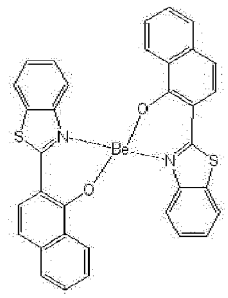
309

According to an embodiment of the present invention, the organic compound that emits fluorescent light may be an anthracene-based compound represented by Formula 400 below: Formula 400

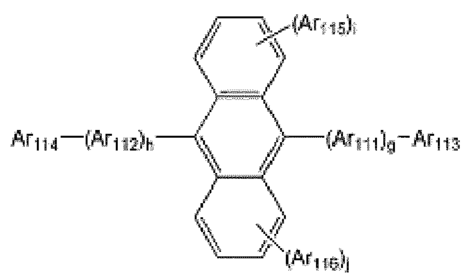

$Ar_{111}$ and $Ar_{112}$ in Formula 400 may be each independently a substituted or unsubstituted $C_6$-$C_{60}$ arylene group; $Ar_{113}$ to $Ar_{116}$ may be each independently a substituted or unsubstituted $C_1$-$C_{10}$ alkyl group or a substituted or unsubstituted $C_6$-$C_{60}$ aryl group; and g, h, i and j may be each independently an integer of 0 to 4.

For example, Arm and $Ar_{112}$ in Formula 400 may be each independently a phenylene group, a naphthylene group, a phenanthrenylene group, or a pirenylene group; or a phenylene group, a naphthylene group, a phenanthrenylene group, a fluorenyl group, or a pirenylene group, each substituted with at least one of a phenyl group, a naphthyl group, or an anthryl group, but embodiments of the invention are not limited thereto.

g, h, i and j in Formula 400 may be each independently 0, 1, or 2.

$Ar_{113}$ to $Ar_{116}$ in Formula 400 may be each independently selected from:

a $C_1$-$C_{10}$ alkyl group substituted with at least one of a phenyl group, a naphthyl group, or an anthryl group; a phenyl group; a naphthyl group; an anthryl group; a pirenyl group; a phenanthrenyl group; a fluorenyl group; a phenyl group, a naphthyl group, an anthryl group, a pirenyl group, a phenanthrenyl group, or a fluorenyl group, each substituted with at least one of deuterium, a halogen atom, a hydroxyl group, a cyano group, a nitro group, an amino group, an amidino group, hydrazine, hydrazone, a carboxyl group or a salt thereof, a sulfonic acid group or a salt thereof, a phosphoric acid or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a phenyl group, a naphthyl group, an anthryl group, a pirenyl group, a phenanthrenyl group, or a fluorenyl group; or

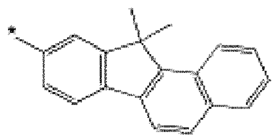,

but embodiments of the invention are not limited thereto.

For example, the anthracene-based compound in Formula 400 may be one of the following compounds, but embodiments of the invention are not limited thereto:

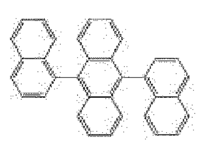
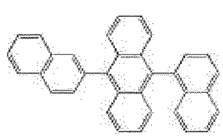
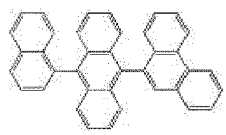
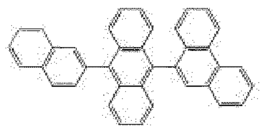

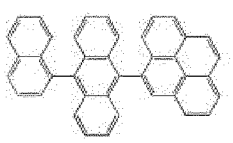
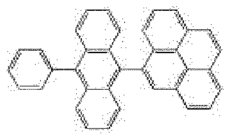
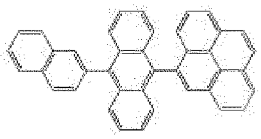
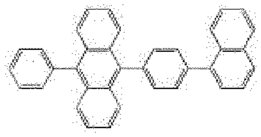

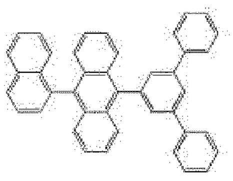
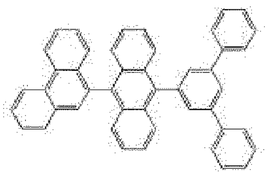
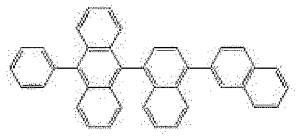

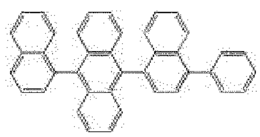
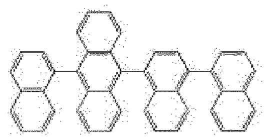
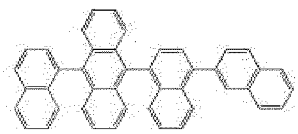

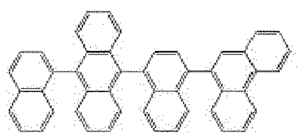
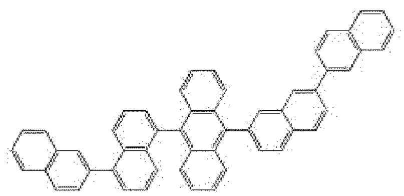
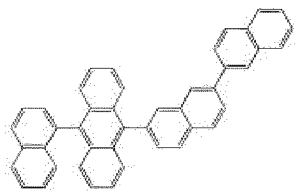

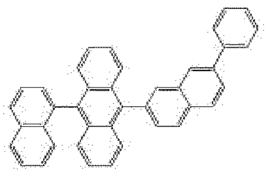
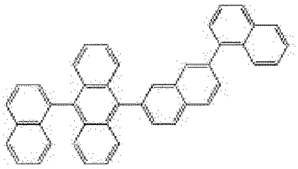
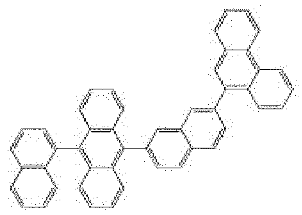

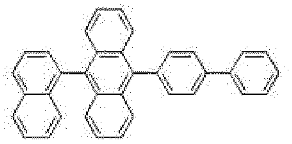
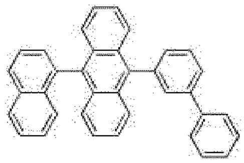
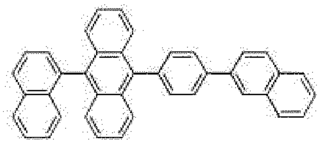

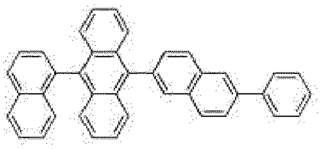
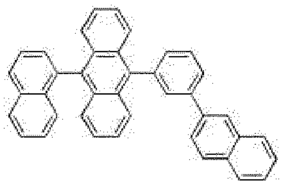
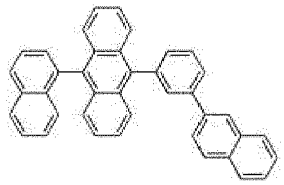

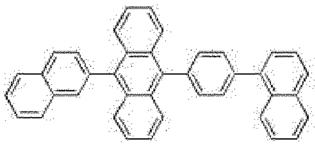
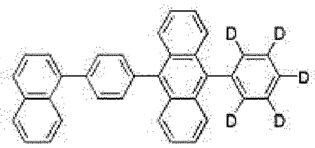
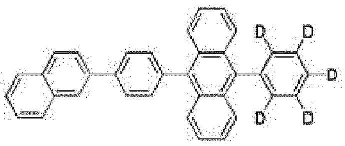

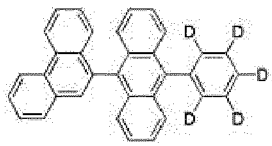
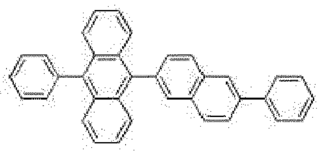
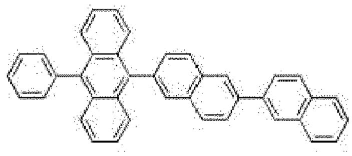

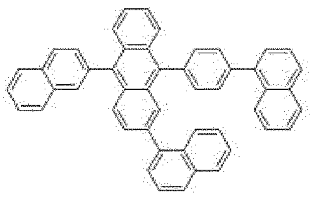
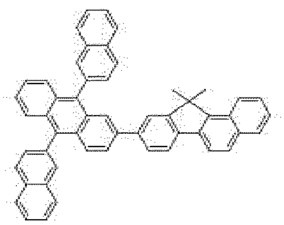
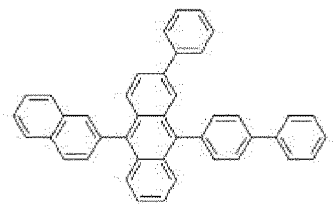

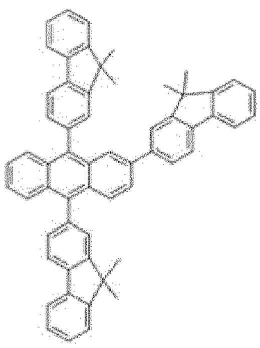
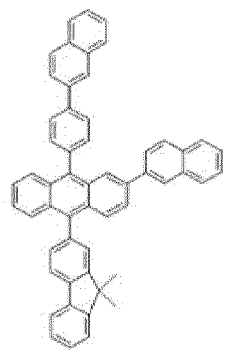
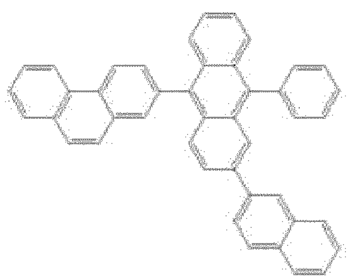

According to an embodiment of the present invention, the organic compound that emits fluorescent light may be an anthracene-based compound represented by Formula 401 below: Formula 401

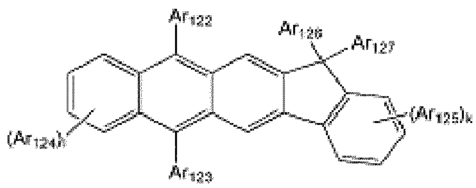

$Ar_{122}$ to $Ar_{125}$ in Formula 401 may be understood by referring to the description provided in connection with $Ar_{113}$ of Formula 400.

$Ar_{126}$ and $Ar_{127}$ in Formula 401 may be each independently a $C_1$-$C_{10}$ alkyl group (for example, a methyl group, an ethyl group, or a propyl group).

k and 1 in Formula 401 may be each independently an integer of 0 to 4. For example, k and 1 may be each independently 0, 1, or 2.

For example, the anthracene-based compound in Formula 401 may be one of the following compounds, but embodiments of the invention are not limited thereto:

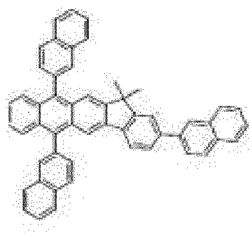

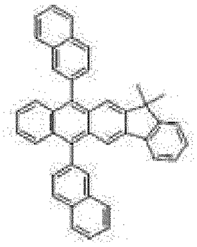

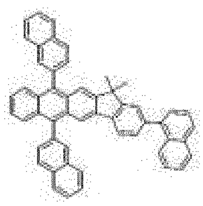

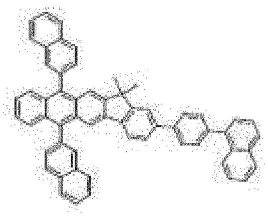

For example, the organic compound that has a light-emission capability may be one of the following compounds:

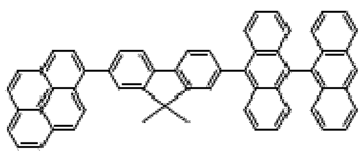

BAnFPye (1-(7-(9,9'-bianthracen-10-yl)-9,9-dimethyl-9H-fluoren-2-yl)pyrene)

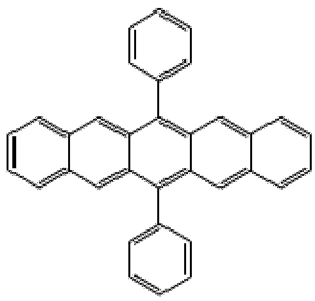

6,13-DP-Penta (6,13-diphenylpentacene)

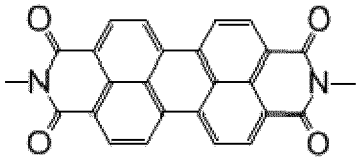

N,N'-dimethyl-3,4,9,10-perylene dicarboximide (MePTC)

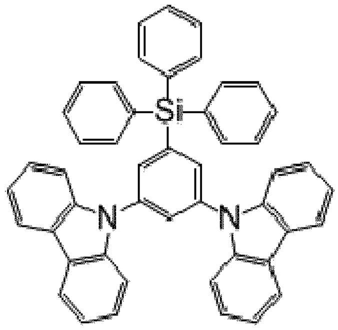

SimCP (9,9'-(5-(triphenylsilyl)-1,3-phenylene)bis(9H-carbazole))

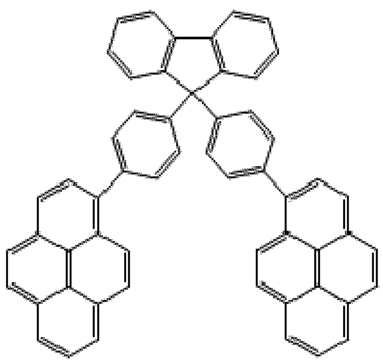

BPPF (9,9-bis[4-(pyrenyl)phenyl]-9H-fluorene)

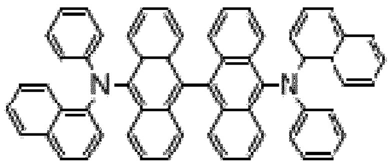

BA-NPB (N10,N10'-diphenyl-N10,N10'-dinaphthalenyl-9,9'-bianthracene-10,10'-diamine).

For example, a light-emission material that is suitable for use in the reflection-prevention layer may be a fluorescent host. When the organic compound is a fluorescent host, examples thereof are 2-methyl-9,10-bis(naphthalen-2-yl)anthracene (MADN), 10,10'-di(biphenyl-4-yl)-9,9'-bianthracene (BANE), and 2-(9,9-spirobifluoren-2-yl)-9,9-spirobifluorene (BSBF).

For example, a light-emission material that is suitable for use in the reflection-prevention layer may be a phosphorescent host. When the organic compound is a phosphorescent host, examples thereof are 1,3,5-tris(carbazol-9-yl)benzene (TCP), 4,4'-bis(carbazol-9-yl)biphenyl (CBP), and 4,4"-di(triphenylsilyl)-p-terphenyl (BST).

A thickness of the reflection-prevention layer including the organic compound in the solar cell module may be in a range of about 1 nm to about 1000 nm. When the thickness of the reflection-prevention layer is less than 1 nm, reflection-prevention effects are negligible (not sufficient), and when the thickness of the reflection-prevention layer exceeds 1000 nm, the light transmittance may decrease.

For example, a thickness of the reflection-prevention layer may be in a range of about 1 nm to about 500 nm.

For example, a thickness of the reflection-prevention layer may be in a range of about 1 nm to about 200 nm. For example, a thickness of the reflection-prevention layer may be in a range of about 50 nm to about 150 nm. When the thickness of the reflection-prevention layer is within these ranges, the solar cell may have improved solar cell efficiency.

The adhesive layer of the solar cell module may include a transparent thermoplastic resin. The transparent thermoplastic resin may include at least one compound selected from an ethylene vinyl acetate (EVA) resin, an urethane resin, a silicone resin, a fluororesin, or polyvinyl butyral.

For example, the adhesive layer may be formed in such a manner that a transparent thermoplastic resin film is first disposed on a window layer, then heat-treated to melt, and then solidified. During the melting and the solidifying, the transparent thermoplastic resin may be thermally cross-linked. For example, a melting temperature of the transparent thermoplastic resin may be 150°C or less. For example, a melting temperature of the transparent thermoplastic resin may be 140°C or less. For example, a melting temperature of the transparent thermoplastic resin may be 130°C or less. For example, a melting temperature of the transparent thermoplastic resin may be 100°C or less. For example, a melting temperature of the transparent thermoplastic resin may be 80°C or less. For example, a melting temperature of the transparent thermoplastic resin may be 70°C or less.

Due to the melting and solidifying of the adhesive layer, the cover layer disposed on the adhesive layer and the solar cell may be attached to each other.

The cover layer may be formed of low-iron flint glass that has a light transmittance of 90% or more in a wavelength range of about 350 nm to about 1,150 nm. A thickness of a glass substrate that forms the cover layer may be in a range of about 1 nm to about 10 mm. A refractive index of the glass substrate may be in a range of 1 to 2.

In the solar cell module, a reflection-prevention layer may be additionally disposed on the cover layer. The reflection-prevention layer additionally disposed on the cover layer may be referred to (or named as) an external reflection-prevention layer. The external reflection-prevention layer may be formed of an inorganic material, such as silicon oxide. A material for forming the external reflection-prevention layer is not particularly limited, and may be any one of various suitable materials that are used to form a reflection-prevention layer in the art.

The light absorption layer of the solar cell module may have the structure of Group I, III, and VIB elements chalcopyrite having p-type conductivity. For example, the light absorption layer may be a thin film including a multinary-compound (e.g., an alloy) semiconductor, such as $CuInSe_2$, $Cu(In,Ga)Se_2$, or $Cu(In,Ga)(S,Se)_2$.

For example, the light absorption layer of the solar cell module may be a thin film including a compound semiconductor having Chemical Structure 1.

Chemical Structure 1 $CuIn_{1-x}Ga_x(S_ySe_{1-y})_2$

wherein o≤x≤1 and 0≤y≤1.

According to an embodiment of the present invention, the light absorption layer may be a selenide-based CIS-based light absorption layer, a sulfide-based CIS-based light absorption layer, or a selenide and sulfide-based CIS-based light absorption layer. The selenide-based CIS-based light absorption layer may include $CuInSe_2$, $Cu(In,Ga)Se_2$, or $CuGaSe_2$; the sulfide-based CIS-based light absorption layer may be $CuInS_2$, $Cu(In,Ga)S_2$, or $CuGaS_2$; and the selenide and sulfide-based CIS-based light absorption layer may include $CuIn(S,Se)_2$, $Cu(In,Ga)(S,Se)_2$, or $CuGa(S,Se)_2$.

In the solar cell module, a surface part (e.g., a surface layer) of the light absorption layer (that is, a portion of the light absorption layer from the surface to about 100 nm depth) may have a sulfur (S) concentration of 0.5 atom% or more. For example, the surface part of the light absorption layer may have a sulfur concentration of 3 atom% or more. Since the surface part of the light absorption layer has a sulfur concentration of 0.5 atom% or more, an optical band gap at a light incident surface increases and thus, incident light may be effectively absorbed. Also, contact interfacial characteristics of the light absorption layer with respect to the buffer layer may improve. According to an embodiment of the present invention, the light absorption layer having a surface layer may include $CuInSe_2$ having $CuIn(S,Se)_2$ as a surface layer, $Cu(In,Ga)Se_2$ having $CuIn(S,Se)_2$ as a surface layer, $Cu(In,Ga)(S,Se)_2$ having $CuIn(S,Se)_2$ as a surface layer, $CuGaSe_2$ having $CuIn(S,Se)_2$ as a surface layer, $Cu(In,Ga)Se_2$ having $Cu(In,Ga)(S,Se)_2$ as a surface layer; $CuGaSe_2$ having $Cu(In,Ga)(S,Se)_2$ as a surface layer, $Cu(In,Ga)Se_2$ having $CuGa(S,Se)_2$ as a surface layer, or $CuGaSe_2$ having $CuGa(S,Se)_2$ as a surface layer.

The light absorption layer may be formed by, for example, seleniding/sulfiding or multi-source concurrent (e.g., simultaneous) deposition. When seleniding/sulfiding is performed, in the case of metal, a metal precursor film (Cu/In, Cu/Ga, Cu-Ga alloy/In, Cu-Ga-In alloy, or the like) having a stack structure or mixed crystal that includes copper(Cu), indium (In), and gallium (Ga) is formed on an electrode by sputtering or deposition, and then, heat-treated in a selenium and/ or sulfur-containing atmosphere to form a light absorption layer. When multi-source simultaneous deposition is performed, a source material including copper (Cu), indium (In), gallium (Ga), and selenium (Se) are co-deposited at an appropriate composition ratio on a glass substrate with a back electrode thereon, wherein the glass substrate is heated to 500°C or higher in advance, to form a light absorption layer.

A thickness of the light absorption layer may be in a range of about 1 $\mu$m to about 3 $\mu$m. For example, a thickness of the light absorption layer may be in a range of about 1.5 $\mu$m to about 2 $\mu$m, but embodiments of the invention are not limited thereto.

The buffer layer of the solar cell module may be a sulfur and zinc-based thin film, but embodiments of the invention are not limited thereto, and may have various compositions as long as being available for use as a buffer layer in the art. For example, the buffer layer may include at least one selected from $Cd_xS_y$, $Zn_xS_y$, $Zn_xO_y$, $Zn_x(OH)_y$, $In_xS_y$, $In_x(OH)_y$, or $In_xO_y$ (wherein x and y may be each independently a natural number of 1 to 10). For example, a thickness of the buffer layer may be in a range of about 1 $\mu$m to about 2 $\mu$m, but embodiments of the invention are not limited thereto.

For example, the buffer layer may be formed by chemical bath deposition (CBD), or metalorganic chemical vapor deposition (MOCVD).

The solar cell module may further include an additional buffer layer formed of an intrinsic ZnO on the buffer layer. A thickness of the additional buffer layer may be in a range of about 10 nm to about 2 $\mu$m. For example, a thickness of the additional buffer layer may be in a range of about 15 nm to about 200 nm, but embodiments of the invention are not limited thereto.

The window layer of the solar cell module may be a film that has an n-type conductivity, a wide band gap, transparency, and low resistance. Such a film may be a zinc oxide-based thin film or an ITO thin film. An n-type window layer may include, in the case of a zinc oxide-based thin film, a Group III element, for example, indium (In), aluminum (Al), gallium (Ga), boron (B), or a combination thereof, as a dopant. The window layer may be a transparent conductive film, and may have a thickness of about 5 nm to about 2.5 $\mu$m. For example, a thickness of the window layer may be in a range of about 50 nm to about 2 $\mu$m, but embodiments of the invention are not limited thereto.

The light absorption layer of the solar cell may be formed on a supporting substrate. The supporting substrate may be a glass substrate, a plastic substrate, or a metal substrate. The supporting substrate may be rigid or flexible. For example, the supporting substrate may be a soda lime glass substrate. A thickness of the supporting substrate may be in a range of about 0.1 $\mu$m to about 100 $\mu$m, but embodiments of the invention are not limited thereto.

In the solar cell, a bottom electrode or back electrode may be formed between the supporting substrate and the light absorption layer. The back electrode may include Mo, Cr, W, or a combination thereof. For example, the back electrode may include Mo. A thickness of the back electrode may be in a range of about 200 nm to about 1000 nm, but embodiments of the invention are not limited thereto.

For example, the solar cell module may have the structure illustrated in the drawing. Referring to the drawing, a metal back electrode layer 2 is disposed on a glass substrate 1, a light absorption layer 3 is disposed on the metal back electrode layer 2, a buffer layer 4 is disposed on the light absorption layer 3, a window layer 5 is disposed on the buffer layer 4, a reflection-prevention layer 6 is disposed on the window layer 5, the adhesive layer 7 is disposed on the reflection-prevention layer 6, and a cover layer 8 is disposed on the adhesive layer 7. Although not illustrated in the drawing, an external reflection-prevention layer may be additionally disposed on the cover layer 8.

A method of manufacturing a solar cell module according to an embodiment of the present invention includes: preparing a solar cell including a window layer; forming a reflection-prevention layer having an organic compound on the window layer of the solar cell; and sequentially disposing an adhesive layer and a cover layer on the reflection-prevention layer in this stated order.

In the method, the reflection-prevention layer may be formed by using a low-temperature film formation method. In the low-temperature film formation method, the term "low-temperature" refers to a temperature of 150°C or lower.

In the method, the low-temperature film formation method may be one selected from vacuum thermal evaporation, spin coating, inkjet printing, casting, Langmuir Blodgett (LB), spray coating, doctor-blading coating, or bar-coating. However, the low-temperature film formation method embodiments of the invention are not limited thereto, and may be any of various suitable methods in the art that allow a film to be formed at low temperature.

For example, when the vacuum thermal evaporation is performed, the film-formation temperature may be room temperature.

The organic compound may be any of the suitable compound described previously for the reflection-prevention layer of a solar cell.

Hereinafter, embodiments of the present invention are described in more detail with reference to Examples and Comparative Examples. However, the embodiments are provided for illustrative purpose only, and do not limit the scope of the invention.

**Manufacturing of a solar cell**

**Preparation Example 1: Use of NPB**

A Mo bottom electrode having a thickness of 0.8 $\mu$m was formed by sputtering on a soda lime glass (SLG) substrate having a size of 50 mm×50 mm. A $Cu(In_{0.7}Ga_{0.3})Se_2$ light absorption layer was formed on the Mo bottom

electrode by multi-source simultaneous deposition. The refractive index of the light absorption layer was about 2.9.

An aqueous solution including 30 mM zinc sulfate ($ZnSO_4$), 0.5 mM silver sulfate ($AgSO_4$), and 5 mM ammonium hydroxide ($NH_4OH$) and having a temperature of 70°C was prepared.

The substrate with the light absorption layer thereon was vertically immersed in the aqueous solution for 12 minutes, and then taken out of the aqueous solution and dried at room temperature to form a ZnS buffer layer. The buffer layer had a thickness of 75 nm and a refractive index of about 2.3.

A boron-doped ZnO (BZO) was deposited on the buffer layer to a thickness of about 450 nm to form a window layer having a refractive index of about 2.0.

NPB represented by Formula 1 below was deposited through vacuum thermal evaporation on the window layer to form a reflection-prevention layer having a thickness of 90 nm and a refractive index of 1.74.

Formula 1

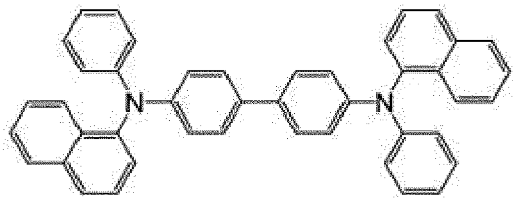

**Preparation Example 2: Use of α-NPD**

A solar cell was manufactured in the same manner as in Preparation Example 1, except that as a material for forming a reflection-prevention layer, α-NPD represented by Formula 2 below was used instead of NPB.

Formula 2

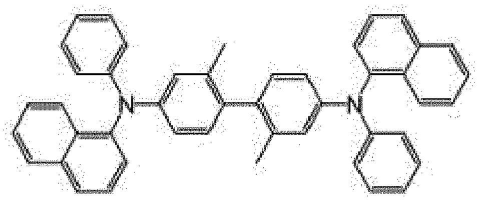

**Preparation Example 3: Use of TPD**

A solar cell was manufactured in the same manner as in Preparation Example 1, except that as a material for forming a reflection-prevention layer, TPD represented by Formula 3 below was used instead of NPB.

Formula 3

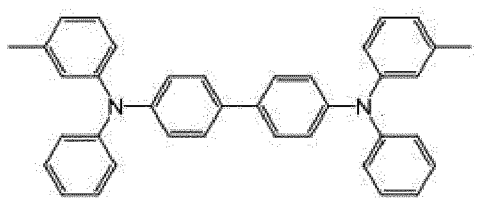

**Comparative Preparation Example 1**

A solar cell was manufactured in the same manner as in Preparation Example 1, except that a reflection-prevention layer was not formed.

**Manufacturing of a solar cell module**

**Example 1: Use of NPB**

A Mo bottom electrode having a thickness of 0.8 μm was formed by sputtering on a soda lime glass (SLG) substrate having a size of 50 mm×50 mm. A $Cu(In_{0.7}Ga_{0.3})Se_2$ light absorption layer was formed on the Mo bottom electrode by multi-source simultaneous deposition. The refractive index of the light absorption layer was about 2.9.

An aqueous solution including 30 mM zinc sulfate ($ZnSO_4$), 0.5 mM silver sulfate ($AgSO_4$), and 5 mM ammonium hydroxide ($NH_4OH$) and having a temperature of 70°C was prepared.

The substrate with the light absorption layer thereon was vertically immersed in the aqueous solution for 12 minutes, and then taken out of the aqueous solution and dried at room temperature to form a ZnS buffer layer. The buffer layer had a thickness of 75 nm and a refractive index of about 2.3.

A boron-doped ZnO (BZO) was deposited on the buffer layer to a thickness of about 450 nm to form a window layer having a refractive index of about 2.0.

N,N'-Bis(naphthalen-1-yl)-N,N'-bis(phenyl)-benzidine (NPB) represented by Formula 1 below was deposited through vacuum thermal evaporation on the window layer to form a reflection-prevention layer having a thickness of 90 nm and a refractive index of 1.74. The glass transition temperature (Tg) of NPB is about 99°C. The reflection-prevention layer hardly absorbed any light having a wavelength of 380 nm or more, and an absorption with respect to light having a wavelength of 400 nm or more was almost 0%.

Formula 1

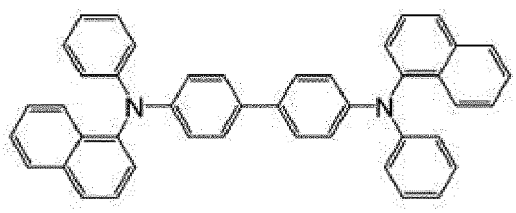

An ethylene vinyl acetate (EVA) film, which acted as an adhesive layer, was disposed on the reflection-prevention layer, and then, a cover glass having a thickness of 3.2 mm and a refractive index of 1.51 was disposed on the EVA film. The construction was heat treated at a temperature of 120°C to melt the EVA film and then was cooled to solidify the melted EVA film to attach the cover glass, which constitutes a cover layer, to the window layer. The EVA adhesive layer had a thickness of 90 nm and a refractive index of 1.49.

**Example 2: Use of α-NPD**

A solar cell was manufactured in the same manner as in Example 1, except that as a material for forming a reflection-prevention layer, N,N'-Bis(naphthalen-1-yl)-N,N'-bis(phenyl)-2,2'-dimethylbenzidine (α-NPD) represented by Formula 2 below was used instead of NPB. α-NPD has a Tg of about 100°C.

Formula 2

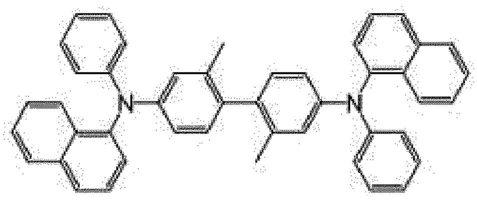

**Example 3: Use of TPD**

A solar cell was manufactured in the same manner as in Example 1, except that as a material for forming a reflection-prevention layer, N,N'-Bis(3-methylphenyl)-N,N'-bis(phenyl)-benzidine (TPD) represented by Formula 3 below was used instead of NPB. TPD has a Tg of about 63°C.

Formula 3

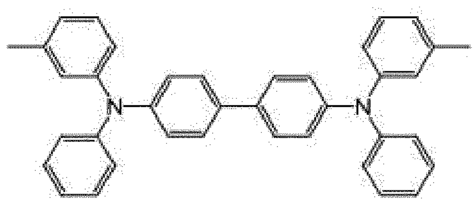

**Comparative Example 1**

A solar cell was manufactured in the same manner as in Example 1, except that a reflection-prevention layer was not formed.

**Evaluation Example 1: Evaluation on reflectance of solar cell**

Reflection ratios of solar cells including the reflection-prevention layers manufactured according to Preparation Examples 1 to 3 and Comparative Preparation Example 1 were measured in a wavelength range of about 400 nm to about 1100 nm.

A reflectance of a reflection-prevention organic thin film layer was measured by using a reflectance measuring device of which the incident angle/reflection angle was set to 30°C. In this regard, the reflectance referred to herein is a reflectance of only a material present at the surface of the reflection-prevention organic thin film layer. Before the reflectance was measured, the surface refractive index was calibrated by using an optical glass (BK-7 glass) as a reference material. The reflectance measuring device was a custom-made product of PSI Co., Ltd.

The measurement results are shown in Table 1 below.

Table 1

| | Reflectance [%] | Decrease in reflectance [%] |
|---|---|---|
| Comparative Preparation Example1 | 4.10% | - |
| Preparation Example 1 | 3.46% | -0.64 |
| Preparation Example 2 | 3.50% | -0.60 |
| Preparation Example 3 | 3.65% | -0.45 |

As shown in Table 1, the reflectance of the solar cells of Preparation Examples 1 to 3 was smaller than the reflectance of Comparative Preparation Example 1.

**Evaluation Example 2: Light conversion efficiency evaluation**

Current-voltage characteristics of the thin film solar cell modules manufactured according to Examples 1 to 3 and Comparative Example 1 were measured when light was irradiated under 1 sun and AM (air mass) 1.5, and also measured in a dark condition. Herein, "1 sun" indicates the intensity of a light source being equivalent to one sun, and "AM 1.5" indicates a filter that adjusts (or modifies) the wavelength of light with respect to that of the solar light when light passes through the filter.

Photocurrent voltage of the thin film solar cell modules manufactured according to Examples 1 to 3 and Comparative Example 1 was measured. Open voltage, current density, and a fill factor were calculated from the obtained photocurrent curve. Conversion efficiency of each of the solar cell modules was evaluated from the obtained results and is shown in Table 2 below.

Herein, a xenon (Xe) lamp was used as the light source, and a solar condition of the xenon lamp was calibrated by using a reference solar cell (Frunhofer Institute Solare Engeriessysysteme, Certificate No. C-ISE369, Type of material: Mono-Si+KG filter), and the photocurrent voltage was measured at a power density of 100 mW/cm$^2$.

The open voltage, photocurrent density, energy conversion efficiency, and fill factor were measured under conditions shown below:

(1) open voltage (V) and photocurrent density (mA/cm$^2$): open voltage and photocurrent density were measured by

using Keithley SMU2400; and

(2) energy conversion efficiency (%) and fill factor (%): energy conversion efficiency were measured by using solar simulator (including Xe lamp 1300W, Oriel], AM 1.5 filter, and Keithley SMU2400) of 1.5 AM 100 mW /cm$^2$, and the fill factor was calculated by using the conversion efficiency and the following equation:
Equation

$$\text{Fill factor (\%)} = \frac{((J x V)_{max}}{J_{sc} \times V_{oc}} \times 100$$

wherein J is a value of the Y axis of the conversion efficiency curve, V is a value of the X axis of the conversion efficiency curve, and Jsc and Voc are respectively intercepts of the respective axes.

Some of calculation results are shown in Table 2 below. In Table 2 below, the decrease in the reflectance is a value obtained by substracting the reflectance of a solar cell module of a given Example from the reflectance of the solar cell module of Comparative Example 1.

Table 2

| | Decrease in reflectance [%] | Conversion efficiency (η) [%] |
|---|---|---|
| Comparative Example 1 | - | 15.25% |
| Example 1 | -0.64% | 15.35% |
| Example 2 | -0.60% | 15.34% |
| Example 3 | -0.45% | 15.32% |

As shown in Table 2, the solar cell modules of Examples 1 to 3 have lower reflectance and higher conversion efficiency than the solar cell module of Comparative Example 1.

A difference in conversion efficiency of Examples 1 to 3 and Comparative Example 1 is in a range of 0.07% to 0.1%. However, this difference occurs only due to the inclusion of an inner reflection-prevention layer. Accordingly, when an external reflection-prevention layer is additionally used, the difference may be further widened.

Also, the solar cell modules of Examples 1 and 2 including an organic compound having high thermal stability (e.g., higher Tg) showed a lower reflectance than the solar cell module of Example 3.

According to embodiments of the present invention, due to the inclusion of a reflection-prevention layer, the reflection ratio of a solar cell module decreases and the convention efficiency of the solar cell module improves.

It should be understood that the example embodiments described therein should be considered in a descriptive sense only and not for purposes of limitation. Descriptions of features or aspects within each embodiment should typically be considered as available for other similar features or aspects in other embodiments.

As discussed, embodiments of the invention can provide solar cell module comprising: a solar cell comprising: a light absorption layer comprising a p-type compound semiconductor; a buffer layer over the light absorption layer; and a window layer comprising an n-type metal oxide semiconductor over the buffer layer; a reflection-prevention layer comprising an organic compound over the window layer of the solar cell; an adhesive layer over the reflection-prevention layer; and a cover layer over the adhesive layer.

In some embodiments, a refractive index of the organic compound has a value that is between a refractive index of the window layer and a refractive index of the adhesive layer. In some embodiments, a refractive index of the organic compound is in a range of about 1.50 to about 2.0.

While one or more embodiments of the present invention have been described with reference to the figures, it will be understood by those of ordinary skill in the art that various changes in form and details may be made therein without departing from the scope of the present invention as defined by the following claims, and equivalents thereof.

## Claims

**1.** A solar cell module comprising:

a solar cell comprising:

a light absorption layer comprising a p-type compound semiconductor;
a buffer layer over the light absorption layer; and
a window layer comprising an n-type metal oxide semiconductor over the buffer layer;

a reflection-prevention layer comprising an organic compound over the window layer of the solar cell;
an adhesive layer over the reflection-prevention layer; and
a cover layer over the adhesive layer.

**2.** The solar cell module of claim 1, wherein a refractive index of the organic compound has a value that is between a refractive index of the window layer and a refractive index of the adhesive layer.

**3.** The solar cell module of claim 1 or 2, wherein a refractive index of the organic compound is in a range of about 1.50 to about 2.0.

**4.** The solar cell module of any one of claims 1 to 3, wherein the organic compound absorbs light having a wavelength of 380 nm or less.

**5.** The solar cell module of any one of claims 1 to 4, wherein a light absorption of the organic compound with respect to light having a wavelength of 400 nm or more is less than 5%.

**6.** The solar cell module of any one of claims 1 to 5, wherein a glass transition temperature of the organic compound is 70°C or more.

**7.** The solar cell module of any one of claims 1 to 6, wherein the organic compound comprises a compound having a hole transport capability in an electric field;
optionally wherein the organic compound comprises a triphenylamine-based compound.

**8.** The solar cell module of claim 7, wherein the organic compound further comprises at least one compound selected from the group consisting of carbazole-based compounds, fluorene-based compounds, compounds having a spiro structure, conductive polymers, perfluorocyclobutyl-based polymers, and photo cross-linkable compounds.

**9.** The solar cell module of any one of claims 1 to 8, wherein the organic compound comprises a compound having an electron transport capability in an electric field;
optionally wherein the organic compound comprises at least one compound selected from the group consisting of phenanthroline-based compounds, oxadiazole-based compounds, and triazole-based compounds.

**10.** The solar cell module of any one of claims 1 to 9, wherein the organic compound comprises a compound having a light-emission capability in an electric field;
optionally wherein the organic compound comprises a compound that emits fluorescent light or phosphorescent light.

**11.** The solar cell module of claim 10, wherein the organic compound comprises at least one compound selected from the group consisting of anthracene-based compounds, biphenyl-based compounds, methylphenyl-based compounds, spirobifluorene-based compounds, pyrene-based compounds, pentacene-based compounds, perylene-based compounds, phenylene-based compounds, pyrenyl-based compounds, and naphthalene-based compounds; and/or
wherein the organic compound comprises at least one compound selected from the group consisting of carbazol-based compounds, triphenylsilyl-based compounds, dimethylamino-based compounds, methylphenyl-based compounds, and t-butylphenyl-based compounds.

**12.** The solar cell module of any one of claims 1 to 11, wherein a thickness of the reflection-prevention layer is in a range of about 1 nm to about 1000 nm.

**13.** The solar cell module of any one of claims 1 to 12, wherein the adhesive layer comprises a transparent thermoplastic resin;
optionally wherein the adhesive layer comprises at least one compound selected from the group consisting of an ethylene vinyl acetate (EVA) resins, urethane resins, silicone resins, fluororesins, and polyvinyl butyral resins.

**14.** A method of manufacturing a solar cell module, the method comprising:

preparing a solar cell comprising a window layer;
forming a reflection-prevention layer having an organic compound on the window layer of the solar cell; and
sequentially disposing an adhesive layer and a cover layer on the reflection-prevention layer in this stated order.

**15.** The method of claim 14, wherein the forming of the reflection-prevention layer is conducted utilizing a low-temperature film formation method;
optionally wherein the low-temperature film formation method is selected from the group consisting of vacuum thermal evaporation, spin coating, inkjet printing, casting, langmuir blodgett (LB), spray coating, doctor-blading coating, and bar-coating.

FIG. 1

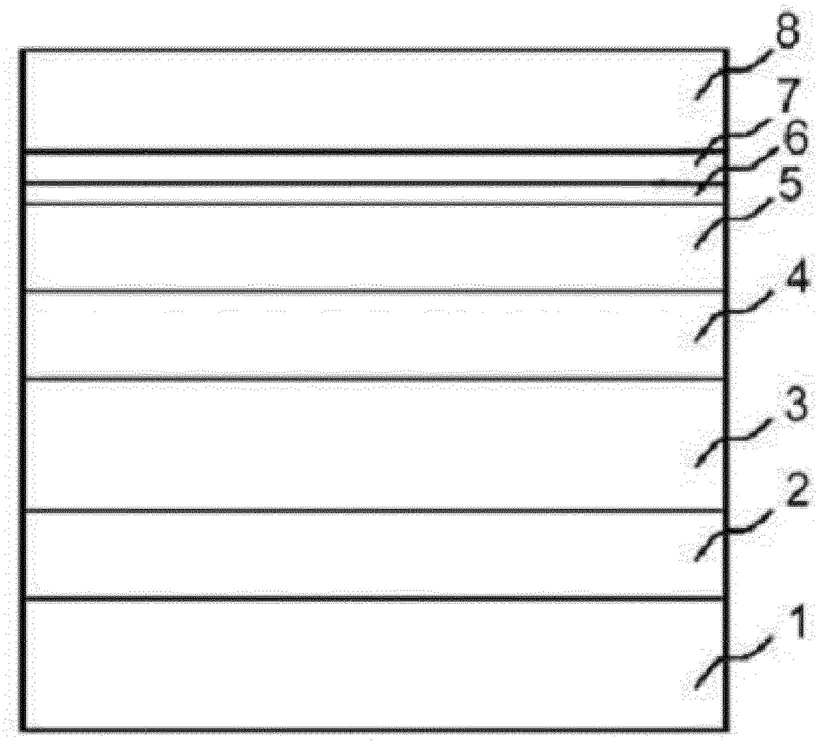

Europäisches Patentamt
European Patent Office
Office européen des brevets

# EUROPEAN SEARCH REPORT

Application Number
EP 14 18 1084

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>Y | US 2010/132765 A1 (CUMPSTON BRIAN H [US] ET AL) 3 June 2010 (2010-06-03)<br>* abstract *<br>* page 12, paragraph 102 - page 15, paragraph 116 *<br>* figures 3A-3U *<br>----- | 1,13-15<br>2-12 | INV.<br>H01L31/0216<br>H01L31/0749 |
| Y | US 2013/056715 A1 (ASAMI YOSHINOBU [JP] ET AL) 7 March 2013 (2013-03-07)<br>* page 2, paragraph 27 - page 4, paragraph 53 *<br>* figures 1,2 *<br>----- | 2-12 | |
| A | SUGIMOTO H. ET AL.: "Challenge to 18% efficiency with 30*30 cm2-sized Cu(InGa)(SeS)2 submodules in solar frontier",<br>PROCEEDINGS / 26TH EUROPEAN PHOTOVOLTAIC SOLAR ENERGY CONFERENCE AND EXHIBITION : THE MOST INSPIRING PLATFORM FOR THE GLOBAL PV SOLAR SECTOR ; CCH CONGRESS CENTRE AND INTERNATIONAL FAIR, HAMBURG, GERMANY, CONFERENCE 5 - 9 SEPTEMBER 2011, EXHIBITION 5,<br>13 October 2011 (2011-10-13), XP040637761,<br>ISBN: 978-3-936338-27-0<br>* abstract *<br>* page 2308, left-hand column, paragraph 1 *<br>* figures 3,4 *<br>----- | 1-15 | TECHNICAL FIELDS SEARCHED (IPC)<br>H01L |
| A | US 2012/125426 A1 (CHUNG YONG-DUCK [KR]) 24 May 2012 (2012-05-24)<br>* page 1, paragraph 19 - page 2, paragraph 35 *<br>* figure 1 *<br>----- | 1-15 | |

The present search report has been drawn up for all claims

1

| Place of search | Date of completion of the search | Examiner |
|---|---|---|
| Berlin | 25 September 2014 | Ekoué, Adamah |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 14 18 1084

This annex lists the patent family members relating to the patent documents cited in the above-mentioned European search report. The members are as contained in the European Patent Office EDP file on The European Patent Office is in no way liable for these particulars which are merely given for the purpose of information.

25-09-2014

| Patent document cited in search report | Publication date | Patent family member(s) | Publication date |
|---|---|---|---|
| US 2010132765 A1 | 03-06-2010 | US 2010132765 A1 | 03-06-2010 |
| | | WO 2011090706 A2 | 28-07-2011 |
| US 2013056715 A1 | 07-03-2013 | CN 103000745 A | 27-03-2013 |
| | | JP 2013058562 A | 28-03-2013 |
| | | US 2013056715 A1 | 07-03-2013 |
| US 2012125426 A1 | 24-05-2012 | KR 20120054927 A | 31-05-2012 |
| | | US 2012125426 A1 | 24-05-2012 |

EPO FORM P0459

For more details about this annex : see Official Journal of the European Patent Office, No. 12/82